# FASCICULE DE BREVET EUROPEEN

(11) **EP 3 213 352 B1**
(45) Date de publication et mention de la délivrance du brevet: **14.04.2021**
(21) Numéro de dépôt: 15784720.3
(22) Date de dépôt: 26.10.2015
(51) Int. Cl.: H01L 31/18, H01L 31/0236

(54) **PROCEDE DE FABRICATION D'UNE CELLULE PHOTOVOLTAÏQUE**
VERFAHREN ZUR HERSTELLUNG EINER FOTOVOLTAIKZELLE
METHOD FOR MANUFACTURING A PHOTOVOLTAIC CELL

(30) Priorité: 27.10.2014 FR 1460289
(43) Date de publication de la demande: 06.09.2017
(73) Titulaire: Commissariat à l'Énergie Atomique et aux Énergies Alternatives, 75015 Paris (FR)
(72) Inventeur: LANTERNE, Adeline, 24460 Saint Front d'Alemps (FR); GALL, Samuel, 56610 Arradon (FR); LE PERCHEC, Jérôme, 38000 Grenoble (FR); PIROT, Marc, 73610 Attignat Oncin (FR)
(74) Mandataire: Cabinet Laurent & Charras
(86) Numéro de dépôt international: PCT/EP2015/074703
(87) Numéro de publication internationale: WO 2016/066570

(56) Documents cités:
- WO-A1-2013/102718
- WO-A2-2012/162704
- SINKE W ET AL: "A COMPARISON BETWEEN EXCIMER LASER AND THERMAL ANNEALING FOR ION-IMPLANTED POLYCRYSTALLINE SILICON SOLAR CELLS", SOLAR CELLS, ELSEVIER SEQUOIA.S.A. LAUSANNE, CH, vol. 20, no. 1, 1 février 1987 (1987-02-01), pages 51-57, XP000037143, DOI: 10.1016/0379-6787(87)90020-2

## Description

### DOMAINE DE L'INVENTION

L'invention a trait au domaine de la fabrication de substrat semi-conducteur comprenant des zones dopées formant une jonction P-N. L'invention s'applique tout particulièrement aux cellules photovoltaïques.

### ETAT DE LA TECHNIQUE

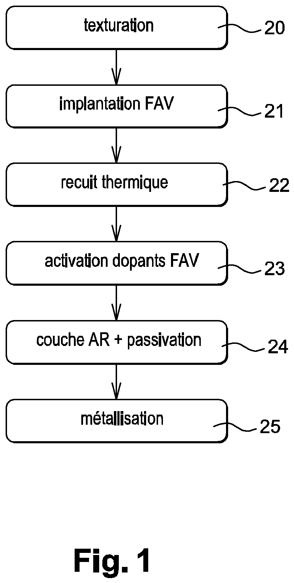

Schématiquement, comme illustré sur la figure 1, une cellule photovoltaïque est formée d'un substrat semi-conducteur, usuellement réalisé en silicium monocristallin ou multicristallin dopé, par exemple dopé *p*, présentant sur au moins l'une de ses faces, usuellement la face avant (ou face active) destinée à recevoir le rayonnement, une structure tridimensionnelle pour améliorer la collecte des photons. En pratique, les deux faces de la cellule photovoltaïque sont texturées de sorte à améliorer la collecte des photons. Sur la face avant texturée, une couche dopée avec un dopage opposé, par exemple une couche dopée *n,* est réalisée, formant ainsi une jonction *pn* pour la collecte des photo-porteurs générés par l'illumination de la cellule. Afin d'améliorer le rendement de la cellule, une zone fortement dopée, du même type de dopage que le substrat, par exemple une couche dite «*p*+» en raison de sa forte concentration en dopant de type p, peut également être réalisée sur l'autre face du substrat, ou face arrière. Cette zone est usuellement dénommée zone «BSF» (acronyme anglo-saxon pour *«Back surface Field* »). En outre, les faces avant et arrière sont recouvertes chacune d'une couche ou de plusieurs couches de passivation limitant les phénomènes de recombinaison des porteurs de charge en surface de la cellule, et augmentant ainsi l'efficacité de la cellule. A titre d'exemple, les faces avant et arrière peuvent être recouvertes d'une couche en nitrure de silicium (SiNₓ) servant à la fois de couche antireflet et de couche de passivation, ou d'une bicouche formée d'une couche de passivation en dioxyde de silicium (SiO₂) et d'une couche antireflet en nitrure de silicium (SiN). La couche en nitrure de silicium servant de couche antireflet peut être déposée en face avant, afin d'augmenter le rendement de la cellule. Enfin, des contacts métalliques sont également présents en face avant et en face arrière pour la collecte des courants.

Globalement, un procédé de fabrication d'une telle cellule photovoltaïque peut comprendre :
- la réalisation d'une plaque mince (ou « wafer » en anglais) en silicium dopé formant le substrat;
- suivie de la texturation d'au moins une face de la plaque de silicium dopée destinée à former la face avant de la cellule ;
- suivie de la réalisation de la couche dopée *n* en face avant pour former la jonction *pn* et éventuellement, la réalisation de la couche dopée p+ sur l'autre face de la plaque mince pour former la zone BSF ;
- suivie éventuellement de la formation des couches de passivation pouvant aussi servir d'antireflet sur la face avant ; et
- suivie de la métallisation en face avant et en face arrière pour réaliser les contacts électriques pour la collecte du courant généré.

Conventionnellement, la texturation de surface, qui est une étape nécessairement mise en œuvre avant la réalisation des autres éléments de la cellule photovoltaïque, consiste à créer une structure tridimensionnelle, généralement sous forme d'une matrice de pyramides, sur au moins la face avant du substrat. Une telle texture peut être obtenue par attaque chimique en plongeant le substrat dans un bain de soude NaOH ou de potasse KOH par exemple, ou encore par attaque plasma. Ce type de texture est notamment adapté pour faire converger un maximum de photons incidents en direction de la face active. En effet, un rayon arrivant à incidence normale sur une pyramide sera réfléchi sur la face d'une pyramide adjacente. Cette double réflexion diminue le coefficient de réflexion totale de la cellule et augmente donc le rendement global de cellule. On comprend donc que la conservation de la forme de cette texture tout au long du procédé de fabrication de la cellule photovoltaïque est essentielle pour garantir un bon rendement de la cellule.

Par ailleurs, la réalisation des couches dopée en face avant et en face arrière du substrat peut être obtenue par différentes techniques connues, telles que par exemple par diffusion gazeuse à haute température à partir de précurseurs gazeux, par diffusion à partir d'une couche diélectrique dopée, ou par implantation ionique par immersion plasma, ou encore par implantation par faisceau d'ions, suivie d'une étape de recuit d'activation qui peut être thermique ou par laser.

En pratique, l'implantation ionique suivie d'un recuit d'activation est une technique privilégiée car elle est localisable sur une seule face, ce qui simplifie le procédé de mise en œuvre et permet un meilleur contrôle du profil des dopants.

Par ailleurs, la réalisation de dopages *n* et *p* nécessite des éléments dopants différents. Par exemple, pour une cellule photovoltaïque à base d'un substrat de silicium dopé p, une méthode consiste à réaliser une implantation ionique de phosphore en face avant pour former la couche n, et une implantation ionique de bore en face arrière pour former la couche BSF. Les atomes de bore nécessitent une température de recuit supérieure à 950°C pour être activés, alors que les atomes de phosphore ne nécessitent que des températures de recuit à partir de 800°C pour être activés.

Dans ce cas particulier, une solution pour activer les dopants consiste à réaliser dans un premier temps l'implantation et l'activation thermique, via un recuit thermique, des dopants nécessitant la température de recuit la plus élevée, ici les atomes de bore, puis dans un deuxième temps à réaliser l'implantation et l'activation thermique, via un autre recuit thermique, des dopants nécessitant la température de recuit moins importante, ici les atomes de phosphore.

Une autre option consiste à réaliser un seul recuit thermique d'activation à une température de recuit permettant l'activation des atomes de bore et de phosphore. Cette solution est cependant moins avantageuse car le profil de phosphore aura trop diffusé et le rendement de la cellule sera moins bon.

L'un et/ou l'autre des recuits thermiques peut être réalisé sous une atmosphère appropriée, afin de former également une couche de SiO₂ de passivation sur des faces avant et arrière de la cellule photovoltaïque.

Si la température d'activation des atomes de phosphore a un impact limité sur la qualité de la cellule photovoltaïque, telle n'est cependant pas le cas de la température d'activation des atomes de bore. En effet, il faut noter qu'un recuit thermique à des températures supérieures à 1000°C est néfaste pour la durée de vie de la cellule, et augmente le risque de contamination métallique.

Pour pallier ce problème de température d'activation trop élevée, une autre solution d'activation, préconisée par le Demandeur et décrite dans le document WO 2013/102718 A1, consiste en l'activation des éléments dopants nécessitant une température minimale d'activation plus élevée, ici les atomes de bore, par un recuit laser, via une irradiation laser de la face correspondante du substrat. L'activation des éléments dopants nécessitant une température d'activation moindre, ici les atomes de phosphore, est par exemple réalisée par un recuit thermique classique.

Le recuit laser ne chauffant les cellules qu'en surface, contrairement au recuit thermique classique qui chauffe le wafer dans tout le volume, cette solution présente donc l'avantage d'éviter la dégradation de la durée de vie de la cellule tout en réalisant des jonctions peu profondes, puisque le bore diffuse très fortement à des températures supérieures à 1000°C.

Toutefois, le Demandeur a constaté que ce procédé ne peut pas être appliqué dans le cas où les éléments dopants présentant une température d'activation plus élevée sont implantés en face avant car dans ce cas, cela engendrerait une perte en réflectivité de la cellule.

Le document WO 2012/162704 A2 et la publication scientifique Sinke W. et Al. : "A comparison between excimer laser and thermal annealing for ion-implanted polycrystalline silicon solar cells", Elsevier Séquoia. S.A., CH, vol. 20, no. 1, 1 février 1987 (1987-02-01), pages 51-57, décrivent également chacun un procédé de fabrication d'une cellule photovoltaïque comprenant la réalisation d'une texturation de surface d'une première face d'un substrat semi-conducteur, l'implantation sur cette première face texturée d' atomes de bore jouant le rôle d'espèces dopantes, et une activation de ces éléments dopants via une irradiation laser.

### EXPOSE DE L'INVENTION

Dans ce contexte, la présente invention a pour but de proposer une solution permettant la mise en œuvre d'un recuit laser pour activer les dopants implantés dans une face texturée du substrat d'une cellule photovoltaïque, en augmentant la réflectivité de la cellule en face avant.

La présente invention a ainsi pour objet un procédé de fabrication d'une cellule photovoltaïque comprenant notamment successivement :
■ à partir d'un substrat semi-conducteur en silicium cristallin dopé selon un premier type de dopage, à savoir de type *p* ou *n,* et comportant une première face et une deuxième face opposée à cette première face, la réalisation d'une texturation de surface d'au moins cette première face du substrat ; et
■ la réalisation, sur la première face texturée, d'une première zone semi-conductrice dopée selon un deuxième type de dopage par implantation de premiers éléments dopants dans au moins une partie du substrat et par activation de ces premiers éléments dopants via une irradiation laser de la première face.

Selon l'invention, les premiers éléments dopants sont des atomes de bore, et le procédé de fabrication comprend en outre un recuit thermique du substrat texturé préalablement à l'irradiation laser de la première face. Ce recuit thermique préalable est réalisé à une température comprise entre 600 et 950°C pendant une durée supérieure à une minute.

En d'autres termes, le Demandeur a observé que lors d'un recuit laser, les énergies utilisées dépassent généralement le seuil limite de fonte du silicium, de sorte que l'utilisation du recuit laser sur une surface texturée comme la face avant de la cellule photovoltaïque fait fondre la texturation de la face avant, d'où une diminution du coefficient de réflexion totale de la cellule photovoltaïque.

La présente invention propose donc un procédé de fabrication d'un substrat semi-conducteur comprenant des zones dopées formant jonction *pn,* dans lequel un recuit thermique du substrat est réalisé préalablement au recuit laser. L'ajout d'un tel recuit thermique, notamment à une température comprise entre 600°C et 950°C, avant l'étape de recuit laser permet en effet de limiter la fonte des pyramides lors du recuit laser ultérieur. Notamment, sans être lié par la théorie, on estime que ce recuit thermique préliminaire peut modifier les caractéristiques mécaniques du substrat en silicium et donc celles de la texturation qui voit sa résistance à la haute température de chauffe induite par le recuit laser, augmentée de façon suffisante pour limiter la fonte de la texturation lors du recuit laser.

Ce recuit thermique préalable peut être réalisé à des températures supérieure à 600°C et inférieure à 950°C. Cette gamme de températures permet notamment de conserver les textures de surface tout en évitant la dégradation de la durée de vie volumique globale du substrat. En pratique, ce recuit thermique préalable peut être réalisé à une valeur fixe de température supérieure à 600°C, par exemple comprise dans la plage de température entre 750°C et 900°C ou dans la plage de température comprise entre 650°C et 850°C, pendant une durée supérieure à une minute. Par exemple, la température de recuit peut être inférieure à 800°C pour limiter les coûts et impacter le moins possible le substrat.

Ainsi, selon un mode de réalisation, la première face texturée du substrat est la face avant ou active de la cellule photovoltaïque destinée à recevoir un rayonnement. Bien entendu, les deux faces avant et arrière du substrat peuvent être texturées.

L'invention selon ce mode de réalisation permet ainsi l'utilisation du recuit laser en face avant sans destruction des textures présentes sur cette face avant grâce au recuit thermique préalable.

En d'autres termes, dans ce mode de réalisation, au moins un recuit laser est prévu pour l'activation des dopants implantés dans la face avant de la cellule.

Il faut comprendre que compte tenu de l'effet du recuit laser sur les textures, l'utilisation du recuit laser n'est avantageuse que pour l'activation des dopants de la face arrière du substrat. Par ailleurs, une étape de dépôt d'une couche antireflet et de passivation peut être généralement prévue dans le procédé de fabrication des cellules photovoltaïques après l'étape de dopage.

En général, la réalisation de la passivation du substrat comprend la formation d'une couche de passivation, avantageusement en oxyde de silicium, sur au moins la face texturée du substrat. Cette passivation des surfaces vise à améliorer la qualité électronique des surfaces du substrat en diminuant le nombre de défauts présents en surface du substrat pour limiter les pertes liées à la recombinaison en surface.

Diverses couches de passivation peuvent être utilisées. En pratique, une couche de passivation peut être obtenue par un autre recuit thermique du substrat, notamment par un recuit thermique d'oxydation par voie sèche ou humide. Cet autre recuit thermique est bien entendu un second recuit thermique distinct du recuit thermique préalable et est réalisé après l'étape de dopage.

En d'autres termes, dans ce cas particulier, le procédé de l'invention comprend au moins deux recuits thermiques bien distincts. Le premier recuit sert notamment à fixer les pyramides présentes sur la face texturée du substrat, et le deuxième recuit permet de réaliser la passivation du substrat.

Par ailleurs, outre la formation de la couche de passivation, il est également possible de prévoir une étape de formation d'une couche antireflet, avantageusement en nitrure de silicium, sur au moins la première face texturée du substrat.

Selon un autre mode de réalisation, le procédé de fabrication comprend en outre la réalisation, sur la deuxième face du substrat, d'une seconde zone semi-conductrice dopée selon le premier type de dopage. Différentes techniques, telles que celles cités ci-avant, peuvent être mises en œuvre pour la réalisation de cette seconde zone semi-conductrice dopée.

Selon une variante, ces secondes zones sont obtenues par implantation de seconds éléments dopants dans au moins une partie du substrat, suivi d'une activation thermique, celle-ci étant avantageusement obtenue par le recuit thermique préalable.

Ces seconds éléments dopants sont distincts des premiers éléments dopants. En particulier, ces seconds éléments dopants sont avantageusement choisis parmi le phosphore ou l'arsenic tandis que les premiers dopants sont du bore.

En d'autres termes, dans cette variante, le recuit thermique préalable décrit ci-avant permet non seulement de conserver les textures, mais également d'activer thermiquement les dopants implantés sur la face du substrat qui ne reçoit pas l'irradiation laser.

Selon une autre variante, l'activation des seconds éléments dopants est réalisée ultérieurement au recuit thermique préalable, et via un autre recuit thermique du substrat ou via une irradiation laser de la deuxième face du substrat.

Lorsque les seconds éléments dopants sont activés par un recuit thermique, ce recuit thermique d'activation peut également permettre de réaliser la passivation du substrat. En d'autres termes, dans ce cas particulier, la passivation et l'activation thermique des seconds éléments dopants peuvent être réalisées simultanément via un même recuit thermique.

Avantageusement, les activations des premiers et seconds éléments dopants et le recuit thermique préalable sont réalisés une fois achevée l'implantation des premiers et seconds éléments dopants.

En pratique, les faces avant et arrière du substrat sont texturées simultanément, puis les éléments dopants sont implantés respectivement pour les faces avant et arrière. Le recuit thermique préalable du substrat est ensuite réalisé pour la conservation de ces textures en face avant et arrière, et les éléments dopants sont enfin activés thermiquement par irradiation laser respective de ces faces.

Avantageusement, le procédé de fabrication comprend en outre le dépôt d'une couche antireflet et/ou de passivation sur au moins la première face, et la métallisation des première et deuxième faces.

Selon un mode de réalisation, l'irradiation laser de la première face est réalisée avec un laser pulsé, dont la longueur d'onde est comprise entre 150 nm et 600 nm, et dont la puissance surfacique est comprise entre 1 et 7 J/cm² avec une durée de pulse comprise entre 10 ns et 1 µs. Une telle irradiation permet d'obtenir une température élevée (supérieure à la température de fusion du silicium et donc une fonte locale de celui-ci) sur une profondeur inférieure au micromètre.

Notamment, l'irradiation laser de la première face comportant des atomes de bore implantés est une irradiation au moyen d'un laser pulsé de fluence de l'ordre de 3 J/cm² et de durée de l'ordre de 150 nanosecondes. Une telle irradiation laser permet notamment d'obtenir une température supérieure à la température de fusion du silicium et donc une fonte locale de celui-ci lors de l'activation thermique des atomes de bore implantés dans l'une des faces du substrat.

De préférence, le substrat, notamment en silicium, présente une épaisseur supérieure à 50 micromètres, typiquement comprise entre 50 et 300 micromètres.

Selon un mode de réalisation, le substrat est un substrat semi-conducteur dopé *p,* la première zone semi-conductrice étant une zone dopée *n*, et la seconde zone semi-conductrice étant une zone dopée *p.*

En variante, le substrat est un substrat semi-conducteur dopé *n,* la première zone semi-conductrice étant une zone dopée *n*, et la seconde zone semi-conductrice étant une zone dopée *p.*

### BREVE DESCRIPTION DES FIGURES

L'invention sera mieux comprise à la lecture de la description qui va suivre, donnée uniquement à titre d'exemple, et réalisée en relation avec les dessins annexés dans lesquels des références identiques désignent des éléments identiques et dans lesquels :
- la figure 1 est un schéma de principe présentant les différentes étapes de réalisation du procédé de fabrication selon un mode de réalisation de l'invention ; et
- les figures 2A à 2G sont des schémas de principe illustrant les étapes de fabrication présentées à la figure 1 ;
- la figure 3 est un schéma de principe présentant les différentes étapes de réalisation du procédé de fabrication selon un autre mode de réalisation de l'invention ; et
- les figures 4A à 4G sont des schémas de principe illustrant les étapes de fabrication présentées à la figure 3 ;
- la figure 5 est un schéma de principe présentant les différentes étapes de réalisation du procédé de fabrication selon un autre mode de réalisation de l'invention ; et
- les figures 6A à 6G sont des schémas de principe illustrant les étapes de fabrication présentées à la figure 5.

### DESCRIPTION DETAILLEE DE DIFFERENTS MODES DE REALISATION PARTICULIERS

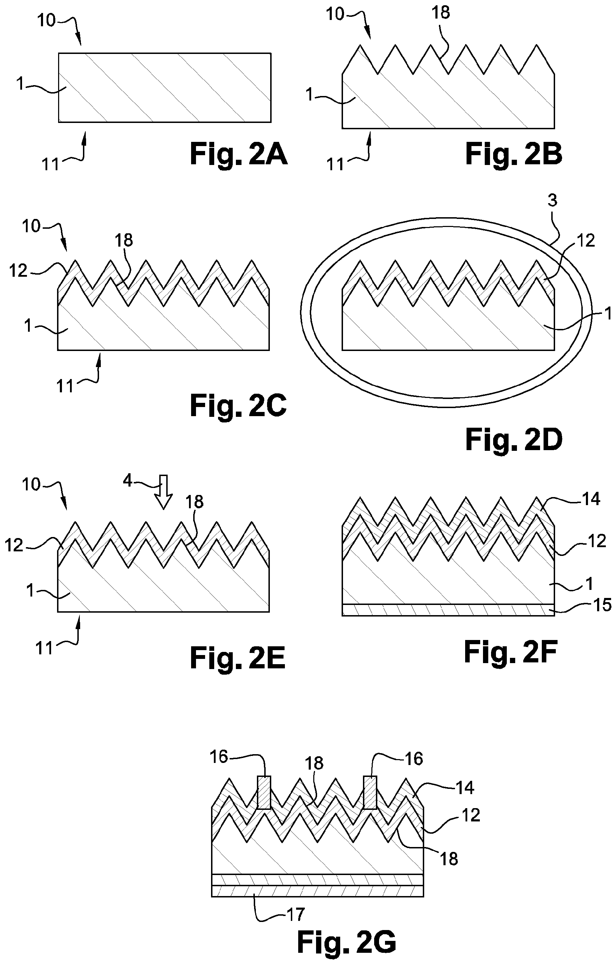

Selon un mode de réalisation illustré aux figures 1 et 2A à 2G, le procédé de fabrication débute notamment par une texturation (étape **20**) d'au moins l'une des faces d'un substrat **1** (figure 2A) en silicium dopé *p* ou *n.* Il s'agit en particulier de la face destinée à recevoir le rayonnement à convertir en courant et dénommée face avant **10**, la face opposée à cette face avant étant dénommée face arrière **11**.

En pratique, le substrat 1 a une épaisseur supérieure à 50 micromètres, notamment une épaisseur comprise entre 50 micromètres et 300 micromètres, par exemple 180 micromètres. Différentes techniques de texturation de surface peuvent être mises en œuvre. Par exemple, il est possible de réaliser une texturation chimique de la face avant par application d'une solution de KOH à 1% à une température 80 °C pendant 40 min, pour créer une rugosité en forme de pyramides **18** (figure 2B).

Le procédé se poursuit ensuite par l'implantation (étape **21**) des éléments dopants, par exemple des atomes de bore, dans la face avant **10** pour former au moins une zone semi-conductrice dopée **12** (figure 2C). L'introduction des atomes de bore dans le substrat 1 peut être réalisée par implantation ionique sur la face avant **10**. Par exemple, une implantation d'ions B⁺ par faisceau d'ions avec une énergie de l'ordre de 10 keV et une dose d'implantation comprise entre 1.10¹³ et 5.10¹⁶ at/cm², par exemple 3.10¹⁵ at/cm². Typiquement, la zone implantée d'atomes de bore présente une épaisseur inférieure à 100 nanomètres. Bien entendu, d'autres techniques d'implantation peuvent être utilisées comme par exemple l'implantation par immersion plasma à partir de fluorure de bore BF₃ ou de diborane B₂H₆.

L'implantation est ensuite suivie d'un recuit thermique (étape **22**) du substrat **1**, notamment à une température fixe, choisie de sorte à être au moins supérieure à 600°C et de préférence entre 750°C et 900°C, et d'une durée de plus d'une minute, pour modifier les caractéristiques physiques des pyramides **18** présentes sur la face avant du substrat, de manière à les rendre plus résistantes à un recuit laser. Ce recuit thermique peut être réalisé dans un four **3** d'oxydation thermique (figure 2D) à pression atmosphérique et sous atmosphère neutre (par exemple avec de l'azote N₂ ou de l'argon) ou oxydante (par exemple avec une atmosphère partielle d'oxygène, tel qu'un mélange azote N₂ et dioxygène O₂).

L'activation thermique (étape **23**) des éléments dopants, ici les atomes de bore, peut ensuite être réalisée par un recuit laser via une irradiation laser **4** (figure 2E) de toute la surface implantée. Ce recuit laser peut être réalisé avec un laser Excimer XeCl pulsé à 308 nm avec une durée de pulse supérieure à 150ns et une densité d'énergie ou fluence égale à 3 J/cm², pour atteindre localement une température supérieure à la température de fusion du silicium. Bien entendu, l'homme du métier saura adapter les paramètres d'irradiation en fonction du laser à sa disposition. Il suffit notamment que les dopants diffusent dans une épaisseur ou profondeur inférieure à un micromètre, et avantageusement inférieure à 500 nm ou 300 nm.

Ainsi, grâce au recuit thermique préalable, la forme des pyramides présentes sur la face avant est globalement conservée lors du recuit laser, alors qu'en l'absence de ce recuit thermique ces pyramides auraient partiellement fondues lors du recuit laser.

La couche antireflet **14** (figure 2F), par exemple en SiNₓ, peut ensuite être déposée (étape **24**) sur la face avant **10** de la cellule, par exemple une couche de 75 nm d'épaisseur de SiNₓ déposée par PECVD (« *Plasma Enhanced Chemical Vapor Déposition* ») de fréquence 440 kHz à une température de 450°C. Une couche antireflet **15** (figure 2F) peut également être déposée sur, ou formée dans, la face arrière **11** (étape **24**), par exemple une couche de 15 nm d'épaisseur de SiNₓ déposée également par PECVD de fréquence 440 kHz à une température de 450°C.

Une couche antireflet, par exemple en SiNₓ, étant usuellement de qualité inférieure en termes de passivation qu'une couche dédiée spécifiquement à la passivation, le procédé comporte avantageusement et de manière optionnelle, avant le dépôt de la couche antireflet, la réalisation d'une couche de passivation sur la face avant 10, une couche de passivation pouvant en outre être réalisée sur la face arrière 1**1** (étape **24**). Cette couche est par exemple une couche de SiOₓ, déposée par PECVD ou obtenue dans l'épaisseur de la cellule au moyen d'un recuit thermique sous atmosphère appropriée, comme cela est connu en soi de l'état de la technique.

Enfin, des contacts électriques **16** en face avant **10** et des contacts électriques **17** en face arrière **11** peuvent avantageusement être réalisés (étape **25**), par exemple sous la forme de grilles (figure 2G) ou pleine plaque, puis un recuit de ces contacts électriques sont réalisé. Bien entendu, la face arrière de la cellule peut être dopée ou non. Différentes techniques d'implantation de dopants peuvent être mise en œuvre pour réaliser la zone dopée en face arrière, comme par exemple l'implantation ionique, la diffusion gazeuse, ou encore le dépôt de couches diélectriques dopées.

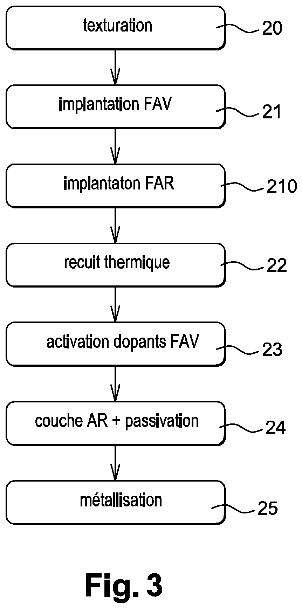

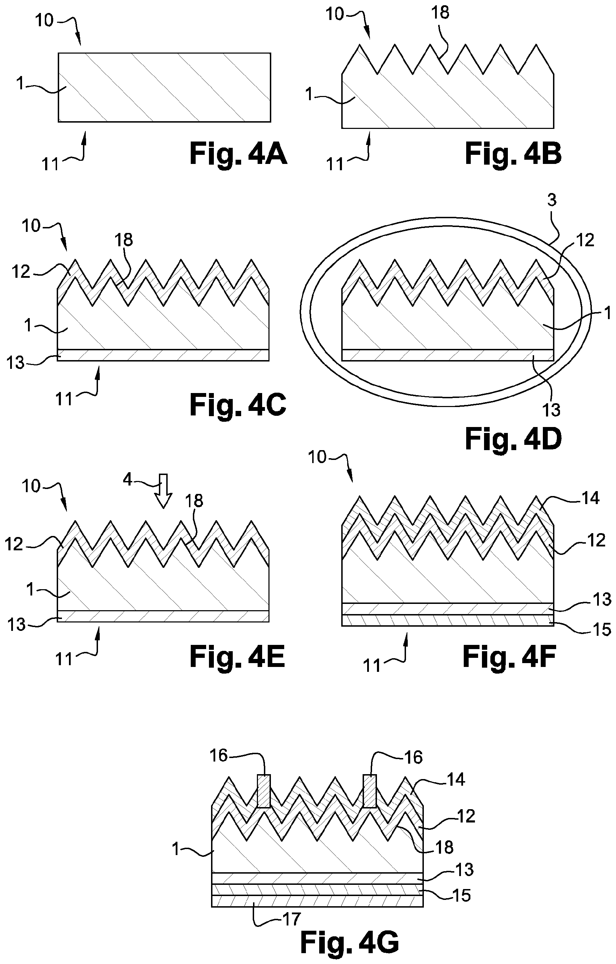

Selon un autre mode de réalisation illustré aux figures 3 et 4A à 4G, dans lequel l'implantation de dopants est réalisée sur les deux faces du substrat **1** (figure 4A), le procédé de fabrication débute comme précédemment par une texturation (étape **20**) de la face avant **10** du substrat **1**. La même technique de texturation décrit ci-avant peut être appliquée pour créer une rugosité en forme de pyramides **18** (figure 4B).

Le procédé se poursuit ensuite par l'implantation (étape **21**) de premiers éléments dopants, par exemple des atomes de bore, dans la face avant **10** pour la formation d'une première zone dopée **12** (figure 4C), et par l'implantation (étape **210**) de seconds éléments dopants, par exemple des atomes de phosphore ou d'arsenic, dans la face arrière **11** pour la formation d'une seconde zone dopée **13** (figure 4C). L'implantation des atomes de bore peut être réalisée comme décrit précédemment pour former la zone semi-conductrice dopée **12** en face avant **10**. L'introduction des atomes de phosphore peut également être réalisée par une implantation ionique pour former la zone semi-conductrice dopée **14** en face arrière **11**, par exemple une implantation d'ions P⁺ par faisceau d'ions avec une énergie de 30 keV et une dose de 4.10¹⁵ at/cm², ou par immersion plasma PH₃.

De préférence, les implantations ioniques de phosphore et de bore sont réalisées dans la même enceinte sous vide d'un dispositif d'implantation ionique.

Après ces implantations, un recuit thermique (étape **22**) est ensuite réalisé pour modifier les caractéristiques physiques des pyramides et pour activer thermiquement les seconds éléments dopants implantés, ici les atomes de phosphore. Dans ce cas particulier, ce recuit thermique est donc réalisé à une température supérieure à 800°C, par exemple à une température de recuit de 840°C dans un four **3** (figure 4D) à oxydation thermique à pression atmosphérique et sous atmosphère neutre (par exemple avec de l'azote N₂) ou oxydante (par exemple avec un mélange azote N₂ et dioxygène O₂). Ce recuit thermique est réalisé de préférence pendant une durée d'au moins une heure.

De préférence, les deuxièmes éléments dopants seront activés lors du recuit formant la couche de passivation en SiO₂, après le recuit laser de bore.

L'activation thermique (étape **23**) des premiers éléments dopants, ici les atomes de bore, peut ensuite être réalisée par un recuit laser via une irradiation laser (figure 4E) de toute la surface implantée. De même, ce recuit laser peut être réalisé avec un laser Excimer XeCl pulsé à 308nm avec une durée de pulse supérieure à 150ns et une densité d'énergie ou fluence égale à 3 J/cm², pour atteindre localement une température supérieure à 1000°C.

De façon similaire au mode de réalisation précédent, une couche antireflet **14** (figure 4F), réalisée après passivation, peut être déposée (étape **24**) sur la face avant **10** et une couche de passivation **15** (figure 4F) peut être déposée sur, ou formée dans, la face arrière **11**. En outre, des contacts électriques **16** en face avant **10** et des contacts électriques **17** en face arrière **11** peuvent également être réalisés (étape **25**).

Ainsi, dans ce mode de réalisation particulier, une seule étape de recuit thermique, réalisée avant l'étape d'activation du dopant de la face avant, permet à la fois de conserver la forme des pyramides présentes sur la face avant et d'activer thermiquement les éléments dopants implantés dans la face arrière du substrat.

Bien entendu, les éléments dopants en face arrière peuvent être activés par un recuit thermique ultérieurement au recuit thermique mis en œuvre pour la conservation des pyramides.

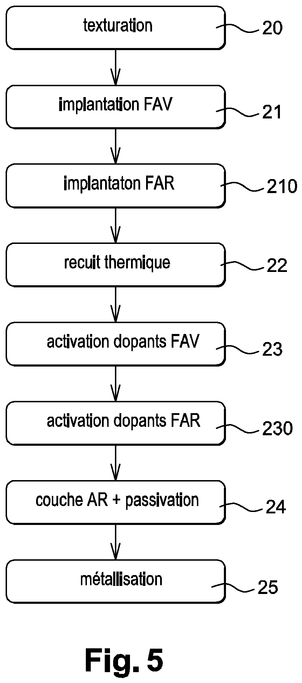

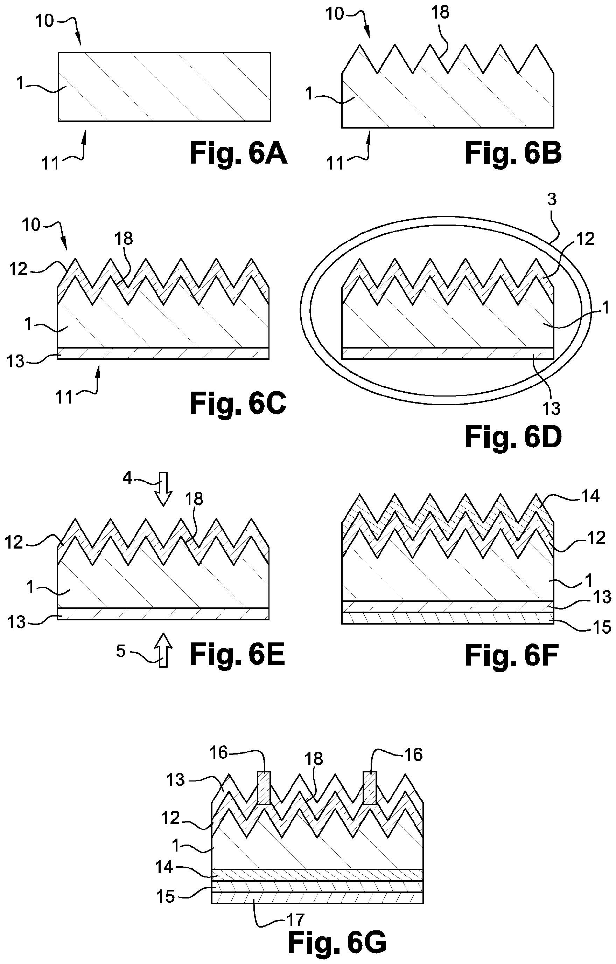

Les éléments dopants en face arrière peuvent également être activés par une irradiation laser. Dans ce cas particulier, illustré aux figures 5 et 6A à 6G, le procédé de fabrication débute comme précédemment par une texturation (étape **20**) de la face avant **10** du substrat 1 (figure 6A). De même, la technique de texturation décrit ci-avant peut être appliquée pour créer une rugosité en forme de pyramides 18 (figure 6B).

Le procédé se poursuit ensuite par l'implantation (étape 21) des premiers éléments dopants, par exemple des atomes de bore, dans la face avant 10 pour former la première zone dopée 12 (figure 6C), et par l'implantation (étape 210) des seconds éléments dopants, par exemple des atomes de phosphore, dans la face arrière 11 pour former la seconde zone dopée 13 (figure 6C). Les implantations des atomes de bore et de phosphore peuvent être réalisées comme décrit précédemment.

Après ces implantations, un recuit thermique (étape 22) est ensuite réalisé pour modifier les caractéristiques physiques des pyramides. Ce recuit peut être réalisé à une température de 750°C par exemple, pendant une durée de plus d'une minute, par exemple pendant dix minutes. De même que précédemment, ce recuit thermique peut être réalisé dans un four 3 (figure 6D) d'oxydation thermique à pression atmosphérique et sous atmosphère neutre (par exemple avec de l'azote N₂) ou oxydante (par exemple avec un mélange azote N₂ et dioxygène O₂).

Une fois ce recuit réalisé, l'activation thermique (étapes 23 et 230) des premiers et seconds éléments dopants, ici les atomes de bore et de phosphore, peut enfin être réalisée par deux irradiations laser successives 4, 5 (figure 6E), l'une sur la face avant et l'autre sur la face arrière. Comme précédemment, l'irradiation laser pour le bore peut être réalisée avec un laser Excimer XeCl pulsé à 308nm avec une durée de pulse supérieure à 150ns et une densité d'énergie ou fluence égale à 3 J/cm², pour atteindre localement la température de fonte du silicium. L'irradiation laser pour le phosphore peut également être réalisée avec un laser Excimer XeCl pulsé à 308nm avec une durée de pulse supérieure à 150ns et une densité d'énergie ou fluence égale à 2 J/cm², pour atteindre localement une température de l'ordre de 840°C.

De façon similaire aux modes de réalisation précédents, une couche antireflet 14 (figure 6F) peut être déposée (étape 24) sur la face avant 10, optionnellement après passivation de la face avant, et une couche de passivation/antireflet 15 (figure 6F) peut être formée ou déposée (étape 24) sur la face arrière 11. En outre, des contacts électriques 16, 17 (figure 6G) en face avant et en face arrière peuvent également être réalisés (étape 25).

Dans tous les modes ci-avant, il est bien entendu possible de réaliser une texturation de la face arrière simultanément à la texturation de la face avant, le recuit thermique réalisé avant l'étape de recuit laser permettant de conserver les textures réalisées sur ces deux faces.

En outre, juste avant ce recuit thermique, un nettoyage chimique du substrat peut être éventuellement réalisé pour améliorer la qualité électrique finale de la zone dopée.

En conclusion, le procédé de l'invention est adapté pour la réalisation de cellules photovoltaïques comprenant notamment un dopage devant être activé à une température supérieure à 950°C, et lorsque l'utilisation d'un recuit thermique classique à ces températures élevées doit être évitée pour ne pas limiter la durée de vie globale de la cellule.

Le procédé de l'invention permet par exemple d'obtenir une zone dopée p+ d'une concentration et d'une profondeur suffisantes pour réaliser une cellule photovoltaïques à émetteur sélectif dopé au bore en face avant (cas notamment où le substrat est de type *n)* tout en conservant les textures en pyramides. Le procédé de l'invention permet également d'obtenir un champ répulsif face avant (ou FSF acronyme anglo-saxon pour *« Front Surface Field* ») dopé au bore (cas où le substrat est de type *p),* tout en conservant les textures en pyramides.

En tant qu'exemple de procédé de texturation et de forme de texturation, il a été décrit une texturation chimique par application d'une solution de KOH pour créer une rugosité en forme de pyramides. On comprend cependant que la forme et la fabrication des rugosités peuvent être différentes, par exemple choisies en fonction de l'application ou du procédé de fabrication. Par exemple, la texturation peut être obtenue par attaque acide (e.g.: HF:HNO₃), par traitement plasma (e.g. ions réactifs avec un mélange gazeux, par exemple SF₆/O₂), par attaque mécanique (e.g. sablage), etc... Les rugosités obtenues peuvent ainsi varier en fonction du processus d'attaque employé (e.g. se présenter sous la forme de crevasses et/ou être plus irrégulières). Une attaque acide pour former des rugosités est par exemple décrit dans le document « Efficiency improved by acid texturation for multi-cristalline silicon solar cells », de Yuang-Tung Cheng et al., Solar Energy, Vol. 85, Issue 1, January 2011, pp 87-94. Une texturation par plasma est par exemple décrite dans le document « Plasma surface texturization for multi-cristalline silicon solar cells », de Martin Schnell et al., IEEE Photovoltaic Specialists Conference, 2000, pp. 367-370.

## Revendications

1. Procédé de fabrication d'une cellule photovoltaïque comprenant successivement :
- à partir d'un substrat (1) semi-conducteur en silicium cristallin dopé selon un premier type de dopage et comportant une première face (10) et une deuxième face (11) opposée à ladite première face (10), la réalisation d'une texturation (20) de surface d'au moins la première face (10) du substrat (1) ;
- la réalisation, sur la première face (10) texturée, d'une première zone semi-conductrice dopée (12) selon un deuxième type de dopage par implantation (21) de premiers éléments dopants dans au moins une partie du substrat (1) et par activation (23) desdits premiers éléments dopants via une irradiation laser (4) de ladite première face (10), lesdits premiers éléments dopants étant des atomes de bore;
**caractérisé en ce que**:
• le procédé de fabrication comprend en outre un recuit thermique (22) du substrat texturé (1) préalablement à l'irradiation laser de la première face (10), ledit recuit thermique préalable (22) étant réalisé à une température comprise entre 600 et 950°C, pendant une durée supérieure à une minute, ledit recuit permettant de limiter la fonte de la texturation (20) de surface lors de l'irradiation laser (4) de ladite première face (10) du substrat.

2. Procédé de fabrication d'une cellule photovoltaïque selon la revendication 1, ***caractérisé* en ce que** la première face (10) du substrat (1) est la face avant de la cellule photovoltaïque destinée à recevoir un rayonnement.

3. Procédé de fabrication d'une cellule photovoltaïque selon la revendication 1 ou 2, ***caractérisé* en ce qu'**il comporte une étape de formation d'une couche de passivation, avantageusement en oxyde de silicium, sur au moins la première face (10) texturée du substrat, par un autre recuit thermique distinct dudit recuit thermique préalable (22).

4. Procédé de fabrication d'une cellule photovoltaïque selon l'une des revendications 1 à 3, ***caractérisé* en ce qu'**il comporte une étape de formation d'une couche antireflet, avantageusement en nitrure de silicium, sur au moins la première face (10) texturée du substrat.

5. Procédé de fabrication d'une cellule photovoltaïque selon l'une des revendications 1 à 4, ***caractérisé* en ce que** la température du recuit thermique préalable (22) est comprise entre 650°C et 850°C.

6. Procédé de fabrication d'une cellule photovoltaïque selon l'une des revendications 1 à 5, ***caractérisé* en ce qu'**il comprend en outre la réalisation sur la deuxième face (11) du substrat (1), d'une seconde zone semi-conductrice dopée (4) selon le premier type de dopage, par implantation (210) de second élément dopants différents des premiers éléments dopants, dans au moins une partie du substrat (1).

7. Procédé de fabrication d'une cellule photovoltaïque selon la revendication 6, ***caractérisé* en ce que** les deuxièmes éléments dopants sont des atomes de phosphore ou d'arsenic.

8. Procédé de fabrication d'une cellule photovoltaïque selon la revendication 6 ou 7, ***caractérisé* en ce que** les seconds éléments dopants sont activés thermiquement par ledit recuit thermique préalable (22).

9. Procédé de fabrication d'une cellule photovoltaïque selon la revendication 6 ou 7, ***caractérisé* en ce que** l'activation des seconds éléments dopants est réalisée ultérieurement au recuit thermique préalable (22), via un autre recuit thermique du substrat ou via une irradiation laser de la deuxième face (11) du substrat (1).

10. Procédé de fabrication d'une cellule photovoltaïque selon l'une des revendications 1 à 7, ***caractérisé* en ce que** l'activation des premiers et seconds éléments dopants et le recuit thermique préalable (22) sont réalisés une fois achevée l'implantation (21, 210) des premier et seconds éléments dopants.

## Patentansprüche

1. Verfahren zur Herstellung einer Fotovoltaikzelle, das nacheinander umfasst:
- ausgehend von einem Halbleitersubstrat (1) aus dotiertem, kristallinem Silizium eines ersten Dotiertyps mit einer ersten Seite (10) und einer zweiten Seite (11), die dieser ersten Seite (10) gegenüberliegt, die Ausführung einer Oberflächentexturierung (20) mindestens der ersten Seite (10) des Substrats (1) ;
- die Ausführung auf der ersten texturierten Seite (10) einer ersten dotierten Halbleiterzone (12) eines zweiten Dotiertyps durch Implantieren (21) der ersten Dotierelemente in mindestens einem Teil des Substrats (1) und durch Aktivierung (23) dieser ersten Dotierelemente mittels einer Laser- Bestrahlung (4) dieser ersten Seite (10), dabei handelt es sich bei den erwähnten ersten Dotierelementen um Boratome;
***dadurch gekennzeichnet, dass:***
• das Herstellungsverfahren außerdem eine thermische Behandlung (22) des texturierten Substrats (1) vor der Laserbestrahlung der ersten Seite (10) beinhaltet, diese thermische Vorbehandlung (22) wird während einer Dauer von mehr als einer Minute, bei einer Temperatur zwischen 600 und 950°C durchgeführt, durch diese Behandlung kann das Schmelzen der Oberflächentexturierung (20) bei der Laserbestrahlung (4) der ersten Seite (10) des Substrats begrenzt werden.

2. Verfahren zur Herstellung einer Fotovoltaikzelle nach Anspruch 1, ***dadurch gekennzeichnet, dass*** die erste Seite (10) des Substrats (1) die Vorderseite der Fotovoltaikzelle ist, die bestrahlt werden soll.

3. Verfahren zur Herstellung einer Fotovoltaikzelle nach Anspruch 1 oder 2, ***dadurch gekennzeichnet, dass*** es einen Schritt zur Bildung einer Passivierungsschicht enthält, vorteilhafterweise aus Siliziumoxid, auf mindestens der ersten texturierten Seite (10) des Substrats durch eine andere thermische Behandlung, die sich von der erwähnten thermischen Vorbehandlung (22) unterscheidet.

4. Verfahren zur Herstellung einer Fotovoltaikzelle nach einem der Ansprüche 1 bis 3, ***dadurch gekennzeichnet, dass*** es einen Schritt zur Bildung einer Antireflexschicht enthält, vorteilhafterweise aus Siliziumnitrid, auf mindestens der ersten texturierten Seite (10) des Substrats.

5. Verfahren zur Herstellung einer Fotovoltaikzelle nach einem der Ansprüche 1 bis 4, ***dadurch gekennzeichnet, dass*** die Temperatur der thermischen Vorbehandlung (22) zwischen 650°C und 850°C liegt.

6. Verfahren zur Herstellung einer Fotovoltaikzelle nach einem der Ansprüche 1 bis 5, ***dadurch gekennzeichnet, dass*** es außerdem die Ausführung einer zweiten dotierten Halbleiterzone (4) gemäß dem ersten Dotierungstyp, auf der zweiten Seite (11) des Substrats (1) enthält, durch Implantation (210) des zweiten Dotierungselement, das sich von den ersten Dotierungselementen unterscheidet, in mindestens einem Teil des Substrats (1).

7. Verfahren zur Herstellung einer Fotovoltaikzelle nach Anspruch 6, **dadurch gekennzeichnet, dass** es sich bei den zweiten Dotierungselementen um Phosphor- oder Arsenatome handelt.

8. Verfahren zur Herstellung einer Fotovoltaikzelle nach Anspruch 6 oder 7, ***dadurch gekennzeichnet, dass*** die zweiten dotierenden Elemente thermisch durch die erwähnte thermische Vorbehandlung (22) aktiviert werden.

9. Verfahren zur Herstellung einer Fotovoltaikzelle nach Anspruch 6 oder 7, ***dadurch gekennzeichnet, dass*** die Aktivierung der weiten dotierenden Elemente nach der thermischen Vorbehandlung (22) durchgeführt wird, mittels einer weiteren thermischen Behandlung des Substrats oder mittels einer Laserbestrahlung der zweiten Seite (11) des Substrats (1).

10. Verfahren zur Herstellung einer Fotovoltaikzelle nach einem der Ansprüche 1 bis 7, ***dadurch gekennzeichnet, dass*** die Aktivierung der ersten und zweiten dotierenden Elemente und die thermische Vorbehandlung (22) ausgeführt werden, sobald die Implantation (21, 210) der ersten und zweiten dotierenden Elemente durchgeführt wurde.

## Claims

1. A method of manufacturing a photovoltaic cell, successively comprising:
- from a crystalline silicon semiconductor substrate (1) doped according to a first doping type and comprising a first surface (10) and a second surface (11) opposite to said first surface (10), forming a surface texturing (20) of at least the first surface (10) of the substrate (1);
- forming, on the first textured surface (10), a first semiconductor area (12) doped according to a second doping type by implantation (21) of first dopant elements into at least a portion of the substrate (1) and by activation (23) of said first dopant elements via a laser irradiation (4) of said first surface (10), said first dopant elements being boron atoms;
***characterized* in that** the manufacturing method further comprises thermally annealing (22) the textured substrate (1) prior to the laser irradiation of the first surface (10), said prior thermal anneal (22) being carried out at a temperature in the range from 600 to 950°C, for a duration longer than one minute, said anneal permitting to limit the melting of the surface texturing (20) during the laser irradiation (4) of said first surface (10) of the substrate.

2. The photovoltaic cell manufacturing method of claim 1, ***characterized* in that** the first surface (10) of the substrate (1) is the front surface of the photovoltaic cell intended to receive a radiation.

3. The photovoltaic cell manufacturing method of claim 1 or 2, ***characterized* in that** it comprises a step of forming a passivation layer, advantageously made of silicon oxide, on at least the first textured surface (10) of the substrate, by another thermal anneal different from said prior thermal anneal (22).

4. The photovoltaic cell manufacturing method of any of claims 1 to 3, ***characterized* in that** it comprises a step of forming an antireflection layer, advantageously made of silicon nitride, at least on the first textured surface (10) of the substrate.

5. The photovoltaic cell manufacturing method of any of claims 1 to 4, ***characterized* in that** the temperature of the prior thermal anneal (22) is in the range from 650°C to 850°C.

6. The photovoltaic cell manufacturing method of any of claims 1 to 5, ***characterized* in that** it further comprises forming on the second surface (11) of the substrate (1) a second semiconductor area (4) doped according to the first doping type, by implantation (210) of second dopant elements different from the first dopant elements, into at least a portion of the substrate (1).

7. The photovoltaic cell manufacturing method of claim 6, ***characterized* in that** the second dopant elements are phosphorus or arsenic atoms.

8. The photovoltaic cell manufacturing method of claim 6 or 7, ***characterized* in that** the second dopant elements are thermally activated by said prior thermal anneal (22).

9. The photovoltaic cell manufacturing method of claim 6 or 7, ***characterized* in that** the activation of the second dopant elements is performed subsequently to the prior thermal anneal (22), via another thermal anneal of the substrate or via a laser irradiation of the second surface (11) of the substrate (1).

10. The photovoltaic cell manufacturing method of any of claims 1 to 7, ***characterized* in that** the activation of the first and second dopant elements and the prior thermal anneal (22) are performed once the implantation (21, 210) of the first and second dopant elements has been achieved.
